Europäisches Patentamt

European Patent Office

Office européen des brevets

(11) Publication number: **0 089 596**
**B1**

# (12) EUROPEAN PATENT SPECIFICATION

(45) Date of publication of patent specification: **25.06.86**

(51) Int. Cl.⁴: **G 06 F 1/04, H 03 K 5/05**

(21) Application number: **83102516.8**

(22) Date of filing: **15.03.83**

(54) **Digital timing unit.**

(30) Priority: **22.03.82 IT 2030482**

(43) Date of publication of application:
**28.09.83 Bulletin 83/39**

(45) Publication of the grant of the patent:
**25.06.86 Bulletin 86/26**

(84) Designated Contracting States:
**DE FR GB**

(56) References cited:
**GB-A-1 018 075**
**US-A-3 108 227**
**US-A-3 564 429**
**US-A-4 134 073**

**COMPUTER DESIGN, vol. 18, no. 12, December 1979, pages 104-107, Littleton, USA, F. CHITAYAT: "Timing circuit generates selectable clock frequencies"**

**IBM TECHNICAL DISCLOSURE BULLETIN, vol. 24, no. 7A, December 1981, pages 3514-3515, New York, USA, J.C.FROMENT et al.: "Timing variations in a mono clocking scheme"**

(73) Proprietor: **HONEYWELL INFORMATION SYSTEMS ITALIA S.p.A.**
**Via Martiri d'Italia 3**
**I-10014 Caluso (Torino) (IT)**

(72) Inventor: **Mantellina, Calogero**
**Via Baracca 5**
**Cerro Maggiore (MI) (IT)**
Inventor: **Zanzottera, Daniele**
**Via Rossini 23**
**Busto Garolfo (MI) (IT)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a digital timing unit for timing data processing systems or units thereof, particularly memory units. As known the operation of data processing systems and of memory units coupled to them must be precisely timed.

It is also known that, notwithstanding the project accuracy, some timing problems may occur during the prototype testing which require timing modifications.

Besides, owing to the fast evolution in electronic technologies the speed performances of several integrated components are rapidly increasing.

According to component evolution, therefore, a full exploitation of component performances requires matching of the timing to such component evolution.

For instance, integrated memory circuits, available on the market in subsequent periods, may have the same external features (number of interconnecting pins, relative lay-out, signal transferred from a determinated pin) but higher and higher working speed.

Such integrated components are generally mounted on a supporting printed circuit board, which also includes the timing unit suitable to control such integrated components.

According to the evolution of memory component performances it is therefore necessary to redesign the timing unit and the supporting printing circuit unless the timing unit is fit for timing modifications.

In the prior art electromagnetic delay lines with intermediate taps have been used as basic element of the timing units.

Such delay lines have the inconvenient to impose fixed timing within each cycle, or a timing changeable in a discrete way by selecting one among several possible intermediate taps.

Besides the attainable timing accuracy is limited by the relatively large tolerances of such kind of components.

In fact these components, however unaffected by temperature changes and free from aging phenomena, may have a great spread in delay time even though they are of the same kind and with the same nominal specifications.

Alternatively timing units have been used which make use of an oscillator for the generation of basic timing pulses with predetermined frequency and of a counter which is made to evolve by the basic pulses.

Timing pulses of a variable length multiple of the basic pulse period can be obtained from the counter outputs, by means of suitable decoding logical networks.

The timing can be modified in a continuous way, therefore proportionally modifying the length of all the timing pulses, by changing the oscillator frequency.

A relative variation in the pulse length is however possible only after modification of the decoding logical network, which practically involves the new designing of the whole timing unit.

In a second alternative, for instance disclosed by US patent No. 4,249,253 published February 3, 1981, cascade shifting registers may be used instead of the counter.

The registers are progressively loaded with a logical/electrical level which propagates through them.

Even in this case the timing pulses are obtained from the shifting register outputs by means of decoding logical network with the above mentioned limits.

Besides, at the end of a timing cycle, the shifting register must be reset to be ready at the subsequent cycle start.

The reset operation simultaneously occurs on a great number of cells and involves a sudden current variation in each of the involved cells.

The amount of the total current change causes the generation of electrical noises which may affect the correct working of the system logical circuits.

Some of these limitations are overcome by a timing circuit disclosed in the article "Timing circuit generates selectable clock frequencies", by F. Chitayat, published on "Computer Design" Vol. 18 (December 1979) N. 12 pages 104—107.

This timing circuit uses a shift register alternatively charged and discharged, owing to clock pulses and from which timing pulses are obtained by means of exclusive OR circuit, both in the charging as well as in the discharging phase.

By selection, through switches, of feedback signals fed to the input from selected register output different cycles durations can be obtained.

The timing circuit is particularly indicated in the timing of microprocessor, where free running clock and timing pulses are required.

It is not suitable for timing memories, where memory cycles must be started asynchronously once a start signal is recieved.

Such limitations and the inconvenients of the prior art are overcome by the digital timing unit object of the present invention, which offers the following advantages:

— it allows to generate very precise timing pulses in response to a start signal;
— it allows to change the timing pulse length in a continuous proportional way for all the timing pulses;
— it allows to change the relative timing length of the timing pulses without substantial circuital modifications, with the only change in electrical interconnections;
— it does not cause electrical noises as it does not require reset operations.

Such advantages are obtained by the use of a shift register where a logical/electrical transition of opposed kind, that is from 0 to 1 in a case and from 1 to 0 in the other one, is alternatively shifted during subsequent timing cycles.

The inputs of a plurality of identical logical circuits, which carry on the logic function EXCLUSIVE OR, are connected to the output of the shifting register.

The EXCLUSIVE OR outputs are preferably, even though not necessarily, connected to an alignment register which "synchronize" one another the several timing pulses in output from logical circuits, recovering the timing spread due to the spread in propagation time of such logical circuits.

The relative timing and the length of the several timing pulses may be modified by means of the only change of the electrical interconnections between shift register and logical circuits.

The features as well as the advantages of the invention as claimed will appear more clearly from the following description of a preferred embodiment of the invention and from the enclosed drawings where:

Fig. 1 shows a preferred embodiment of a digital timing unit according to the invention.

Fig. 2 shows in timing diagram the logical electrical level of the signal present at the different points of the unit in Fig. 1.

Fig. 3 shows a variant to timing unit in Fig. 1.

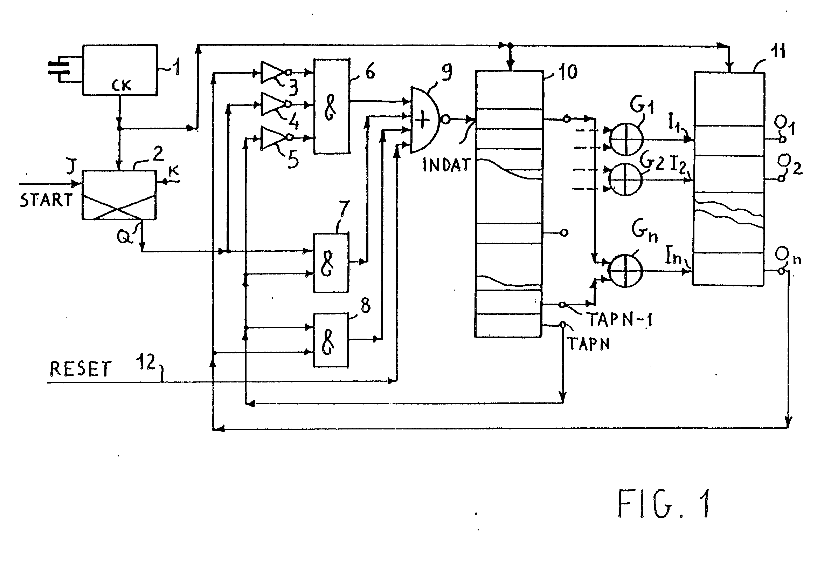

Fig. 1 shows a preferred embodiment of a digital timing unit.

The timing unit includes: a quartz oscillator 1, a flip-flop 2, three NOT elements respectively (3, 4, 5) three AND gates 6, 7, 8 respectively with three inputs (AND gates 6) and two inputs (AND gate 7 and 8), a four inputs NOR gate 9, a shift register 10, a set of n EXCLUSIVE OR gates G1, G2,..., Gn and an auxiliary register 11.

Shift register 10 has a data input INDAT and a set of output terminals TAPO, TAPN.

Auxiliary register 11 has a set of inputs I1,...In and a corresponding set of outputs O1,...On.

The above mentioned elements are interconnected as follows.

The output of oscillator 1 is connected to the clock input of flip-flop 2 and of register 10, 11.

The direct output Q of flip-flop 2 is connected to a first input of AND gate 7 and to the input of NOT 4 whose output is connected to a first input of AND gate 6.

The output terminal TAPN of register 10 is connected to a first input of AND gate 8, to a second input of AND gate 7, as well as to the input of NOT 5 whose output is connected to a second input of AND gate 6.

The output On of register 11 is connected to a second input of AND gate 8 and to the input of NOT 3, whose output is connected to the third input of AND gate 6.

The output of AND gate 6, 7, 8 is respectively connected to three inputs of NOR gate 9.

NOR gate 9 receives, through lead 12, an external RESET signal for initialization purpose.

The output of NOR gate 9 is connected to the data input INDAT of shift register 10.

Output terminals TAPO,...TAPN, of shift register 10, are suitably connected in pairs to the inputs of the n EXCLUSIVE OR gates G1...Gn depending on the timing requirements.

Such interconnections are intentionally shown in dotted lines in order to evidence that the actual connections are not relevant to the invention purpose.

On the contrary a fixed connection is made between terminal TAPO and a first input of gate Gn and between terminal TAPN-1 and the second input of gate Gn.

The outputs of gates G1...Gn are respectively connected to inputs I1...In of register 11.

Flip-flop 2 of JK type receives at input J, through lead 14, a START signal.

The operation of the timing unit is the following:

As soon as the unit is powered, oscillator 1 starts the generation of a sequence of square wave pulses with a characteristic period T, for instance 30 nsec. and goes on indefinitely as it is powered.

Oscillator pulses trigger flip-flop 2 and registers 10, 11 to load the signal present at their respective inputs.

If signal START on lead 14 is missing, flip-flop 2 will therefore remain in reset state.

Register 10 is forced in a known initial reset status where each of its cells is at logical/electrical level 0, by means of a RESET pulse applied on lead 12 and having a length at least equal to $T(N+1)$ where T is the oscillator period and $(N+1)$ the cell number of shift register 10.

The consequence is that at the end of such pulse all the outputs G1,...,Gn of the EXCLUSIVE OR are at logical/electrical level 0 as well as register 11 outputs.

The logical level 0 present at terminal TAPN inhibits AND gates 7 and 8.

On the contrary on all the inputs of AND gate 6 a logical/electrical level 1 is present.

This is because the output Q of flip-flop 2 is at logical level 0 as well as the terminal TAPN and the output On of register 11.

The consequence is that, even though the reset pulse ends, AND gate 6 supplies a logical level 1 to the input of NOR9 which supplies in turn a logical level 0 to INDAT input of shift register 10 which is kept, during the subsequent clock pulses in a discharged status.

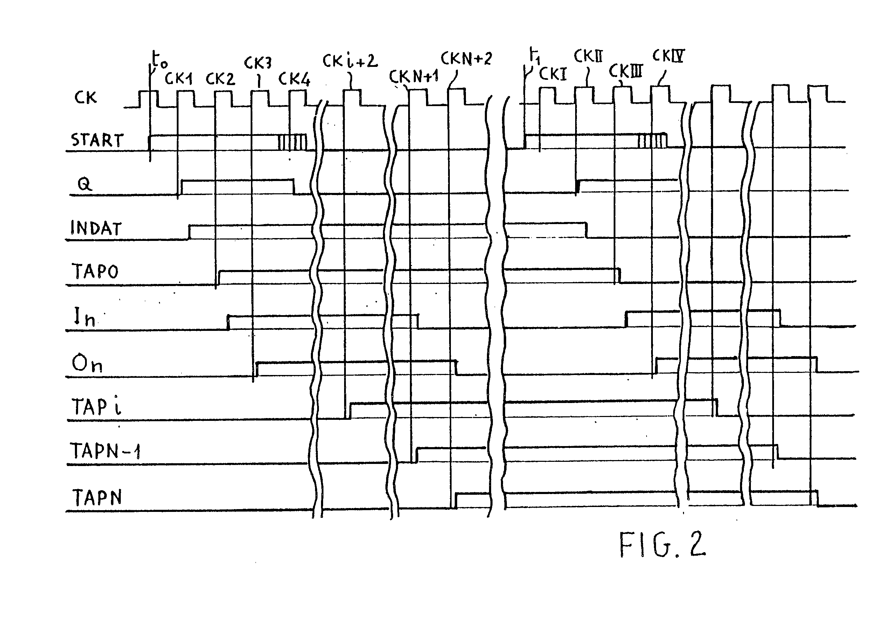

Such initial status is shown by timing diagram of Fig. 2, where:

— the logical/electrical level at output Q is shown by diagram Q;
— the logical/electrical level at the input J of flip-flop 2 is shown by diagram START;
— the timing pulses in output from oscillator 1 are shown by diagram CK;
— the logical/electrical level at the output of NOR gate 9 is shown by diagram INDAT;
— the logical/electrical level at terminals TAPO, TAPi, TAPN-1, TAPN, is respectively shown by diagram TAPO, TAPi, TAPN-1, TAPN.
— the logical/electrical level at input In of register 11 is shown by diagram In.

— the logical/electrical level at output On of register 11 is shown by diagram On.

If at istant $t_0$, in an asynchronous way as to clock inputs, a START pulse is applied to flip-flop 2, with the rising edge of the immediately subsequent clock pulse (CK1), flip-flop 2 is set and output Q rises to logical level 1.

The consequence is that the output of NOR 4 falls to logical level 0 as well as the output of AND gate 6.

Thus the output of NOR gate 9 rises to logical level 1.

These transitions obviously occur with a certain delay as to clock CK1 but anyway before the starting of the subsequent clock CK2.

With clock CK2 a logical level 1 is therefore loaded in the first cell of shift register 10 and terminal TAPO rises to logical level 1.

Since terminal TAPN-1 is still at logical level 0, the output of EXCLUSIVE OR On rises to logical level 1 with a certain propagation delay (diagram In).

With subsequent clock CK3, logical level 1, which is present at input In, is loaded in cell n of register 11 and is available at output On.

Likewise a logical level 1 will be present at all outputs Oi of register 11 which have the corresponding inputs Ii at logical level 1.

This occurs in case other gates Gi, in addition to gate Gn, have an input connected to terminal TAPO.

Therefore with clock CK3 the logical level 1 present at output On inhibits AND gate 6 and imposes a logical level 1 at the output of NOR 9 independently from the logical level present at output Q which is masked.

Therefore, straight after clock CK3 the START pulse may be dropped to 0 and flip-flop 2 may be reset by the immediately subsequent clock pulse.

In other words START pulse must have a minimum length greater than three clock periods.

With clock CK3 logical level 1 present in the first cell of register 10 propagates in the second cell while the first one maintain its logical level 1, so that TAP 1 too rises to logical level 1.

During the subsequent clocks CKi+2 the several terminals TAPi rise to logical level 1.

In other words a logical level 1 propagates in shift register 10 and produces, owing to the connections between terminals TAPi and inputs of gates Gi, the generation of timing signals of a predetermined length which develops in a timing cycle.

Such signals are transferred, for use by external circuits, through register 11.

Register 11 function is only to synchronize the start and the end of timing signals with clock pulses, avoiding the spread which may be caused by gates Gi owing to the different propagation times such gates may have.

In fact register 11 may be constituted by single integrated circuit or by few of them.

It is well known that within the same integrated circuit the spread in propagation time of its functional elements is minimum.

With clock CKN+1 logical level 1 is loaded into cell N-1 of register 10 and therefore terminal TAPN-1 rises to logical level 1 while output of gate Gn falls to logical level 0.

With subsequent clock CKN+2 the timing cycle ends.

Output On of register 11 falls to logical level 0 while terminal TAPN rises to logical level 1.

During the subsequent clock pulses, if a new command START is missing, the shift register does not change its status.

In fact logical level 1 present at terminal TAPN imposes a logical level 0 at the output of AND gate 6, independently from the logical level present at outputs Q and On.

At the same time a logical level 0 present at output On inhibits AND gate 8 while the logical level present at output Q inhibits AND gate 7.

The output of NOR gate 9 is therefore maintained at logical level 1.

If now a new START signal is applied to the timing unit (istant $t_1$) flip-flop 2 is set again by the immediately subsequent clock pulse CKI.

Consequently the output of AND gate 7 rises to logical level 1 and the output of NOR gate 9 falls to logical level 0.

With clock CKII a logical level 0 is therefore loaded in the first cell of shifting register 10 and during the subsequent clocks it propagates in the other cells.

Therefore a new timing cycle starts during which timing signals are generated identical to the ones generated during the previous cycle.

In fact the EXCLUSIVE OR circuits are, by nature, sensitive to differences in logical levels present at the inputs but not to their arrangement.

Likewise to what is seen occuring in the previous cycle, when the clock pulse CKIV is issued, the logical level 1, present on both output On and terminal TAPN, imposes a logical level 1 to the output of AND gate 8.

A logical level 0 is produced at the output of NOR gate 9, independently from the logical level present at output Q.

Thus, even in this case the signal START can be removed.

Finally, as soon as level 0 propagates in register 10, logical level 0 presents both at terminal TAPN, at output On and at output Q, imposes a logical level 1 to the output of AND gate 6 and therefore a logical level 0 to the output of NOR 9.

Therefore shift register 10, during the subsequent clock is maintained in a discharged status until a new START signal is received.

Once explained the operation of the timing unit, object of the present invention, some relevant considerations can be made.

Differently from timing units known in the art where each timing cycle starts always from one predetermined status of the timing unit, the timing unit object of the invention may perform identical timing cycles starting from *two possible*

initial status and terminating in *one of two possible status*.

To this purpose a start command received by the unit enable the unit itself to pass from an initial status to the other one.

A signal in output from gate Gn may be considered a feedback signal which maintain the unit enabled, even though the start command is removed, for the time necessary to complete the timing cycle.

The signal in output from terminal TAPN may be considered a feedback signal which maintain the timing unit in *one of the two possible initial status* reached at the end of a cycle.

On the contrary, in the units known in the art a feedback signal always reset the unit in the same state.

The generation of identical timing signal during timing cycle started from different statuses is performed by means of EXCLUSIVE OR coupled to shifting register 10.

Once clarified these concepts, it is clear that the circuit formed by gates 6, 7, 8, 9 and by NOT 3, 4, 5 and by flip-flop 2 can be embodied by different components, provided the same operation is performed, that is:

— to send a start signal enabling the shifting register to pass from a first to a second status
— to maintain such transition enabled even after start signal is removed
— to maintain the shifting register in the status reached at the end of the transition until the receiving of a new start command.

As already mentioned, register 11 too is not essential for the invention purposes even though it is suggested to cut at the minimum the spread of the starting and ending istants of the timing signal as to the clock pulses.

It is clear that, in case register 11 is not included in the timing unit, EXCLUSIVE OR input Gn is to be connected to a terminal TAPN.

In case the start signals received by the unit are sufficiently long the connection of an input of gate Gn to terminal TAPO may be replaced by the connection to an intermediate terminal TAPi.

Finally the described timing unit may be modified for generation of timing cycles of different length according to conditions or events which may occur during a cycle.

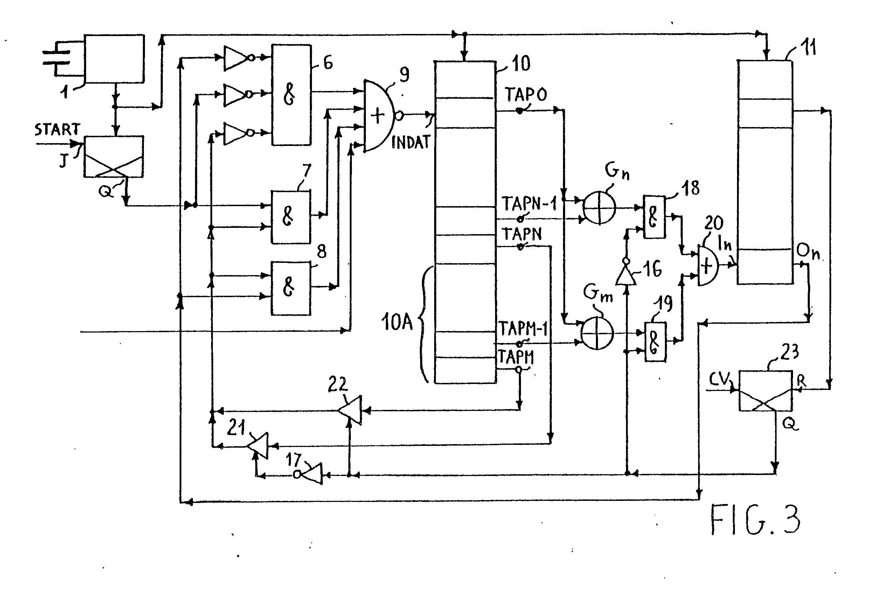

Fig. 3 shows a variant to timing unit of Fig. 1 for the purpose of generating timing cycles of different length.

Timing unit 3 includes all the circuital elements of Fig. 1 identified by the same reference numbers.

For such elements any further description is omitted.

Shift register 10 comprises a "tail" 10A with M cells, each one having an output terminal TAPN+1,..., TAPM.

It also comprises a suitable number of additional EXCLUSIVE OR, of which only the EXCLUSIVE OR Gm is shown, two NOT circuits 16, 17, two AND gates 18, 19 an OR gate 20, two transferring gates of "tristate" type 21, 22 and an RS type flip-flop 23.

Inputs of EXCLUSIVE OR Gm are respectively connected to terminals TAPO and TAPM-1.

The outputs of EXCLUSIVE OR Gn and Gm are respectively connected to a first input of AND gates 18, 19 whose outputs are connected to the inputs of OR20.

The output of OR20 is connected to input In of register 11.

Flip-flop 23 receives at its set input a signal of verified condition CV and at its reset input a timing signal coming from a cell of register 10.

Such timing signal is generated at the beginning of each timing cycle and causes or confirms the reset status of flip-flop 23.

Direct output Q1 of flip-flop 23 is connected to a second input of AND gate 19 and to the enabling input of tristate 22.

It is also connected to the input of NOT 16 and 17 whose output is respectively connected to a second input of AND gate 18 and to the control input of tristate 21.

The input of tristate 21, 22 is respectively connected to terminals TAPN and TAPM and the outputs are connected together, to the input of NOT 5 and to an input of AND gates 7, 8.

Considering Fig. 3 it is clear that during a timing cycle if the condition CV, which require an extension of the timing cycle, does not occur, flip-flop 23 is maintained in reset status, gate 19 is inhibited as well as tristate 22.

On the contrary gate 18 and tristate 21 are enabled.

Therefore the timing unit performs in the same way as the one of Fig. 1.

Instead, if during a timing cycle flip-flop 23 is set AND gate 19 and tristate 22 are enabled.

In such case the action performed by EXCLUSIVE OR Gn is carried out by the EXCLUSIVE OR Gm and the signal in output from terminal TAPM substitutes for the signal in output from terminal TAPN.

The length of a timing cycle is therefore extended for M clock periods.

It is clear that during such timing cycle extension additional timing signals may be generated and some timing signals, already started during the normal cycle, may be extended.

In case of a non extended cycle, such additional signals or such extensions may be masked at the output of the EXCLUSIVE OR which generates them, by means of logic circuits similar to the one used to mask the output of gate Gm.

In case condition CV occurs within each cycle with a delay, as to the start of the cycle, sufficient for a level transition to propagate from the beginning to the end of tail 10A, the presence of tail 10A in shift register 10 does not prevent from the start of a timing cycle which immediately follows the end of a previous short unextended cycle.

It is clear that when a timing unit is designed to supply a certain number n of timing signals at

outputs $O_1...O_n$, the length and the relative timing of such signals may be varied as follows.

For proportional variations of all the timing pulses it suffices to change the oscillator 1 period.

For variation of relative length it is possible to modify the start and the end of the timing signals according to discrete values equal to the oscillation period T by changing the connections among the terminals TAPi and the input of gates Gi.

This may be carried out by the modification of the printing circuit supporting the components or by effecting such connections through straps changeable according to the needs.

Obviously it is possible to carry out combined timing modifications by acting both on the oscillator period and on the connections.

A list of preferred components available on the market for implementation of the timing unit object of the invention is supplied.

Oscillator 1:

Integrated circuit K1115A manufactured by US firm MOTOROLA.

It has a maximum oscillation frequency of 70 MHz.

Flip-flop 2, 23:

Integrated circuit 74S112 manufactured by US firm FAIRCHILD.

The integrated component includes two JK flip-flops having further a set/reset direct input.

The typical propagation time of the components is 5 ns.

AND 6, 7, 8 and NOR 9:

The AND NOR integrated circuit having code 74F64 and manufactured by FAIRCHILD may be used.

The propagation time of the component is 4,5 nsec.

AND 18, 19:

The integrated circuit with code 74F08 manufactured by FAIRCHILD may be used.

The propagation time of the component is 4 nsec.

NOT 3, 4, 5, 16, 17:

Integrated circuit 74F04 manufactured by US firm FAIRCHILD.

The component includes 6 NOT. The propagation time of the component is 3,5 nsec.

Register 10, 10A, 11:

Integrated circuit 74F374 manufactured by FAIRCHILD.

The component includes 8 cells.

The propagation time of the component is 5,5 nsec.

The register may be used as shift register by connecting the output of each cell (TAPi) to the input of the subsequent cell.

The component is further characterized by the absence of "spikes" or output level transitions in correspondence of the loading clocks, when the output logical level does not change.

Registers with greater capacity are obtained by arranging several components of such kind in parallel or in cascade (in case of shift registers).

OR 20:

Integrated circuit 74F32 manufactured by FAIRCHILD.

The component include 4 OR with two inputs.

The propagation times of the component is 4 nsec.

TRISTATE 21, 22:

Integrated circuit 74F241 manufactured by FAIRCHILD.

The component include 8 tristates.

EXCLUSIVE OR $G_i$:

Integrated circuit 74F86 manufactured by FAIRCHILD.

Propagation time 5 nsec.

The component includes 4 EXCLUSIVE OR.

Considering the propagation time of the above components it appears that such circuits allow to implement a timing unit having a typical clock period of about 16 nsec. in case of Fig. 1 and of about 23 nsec. in case of Fig. 3.

**Claims**

1. Digital timing unit in which a shift register (10) has a plurality of N ordered cells, a first cell input (INDAT) and an output (TAPi) for each cell, a clock input for loading in the first cell the logical signal level present to the corresponding cell input and for shifting the logical content of a cell in the subsequent one at each received clock pulse,

in which a plurality of EXCLUSIVE OR circuits (G1, G2, Gn) has each are input pair connected to a preestablished output pair of said shift register and

in which a clock pulse generator (1) provides at its output a sequence of clock pulses having a preestablished frequency, said clock pulses being fed to said clock input,

a logical circuit means (2, 3, 4, 5, 6, 7, 8, 9) having an output providing said first cell input with either one or the other of a binary signal level and having inputs for receiving feedback signals from said shift register cells to cause said shift register to pass in one timing cycle, from a first status with cells containing a first signal level to a second status with cells containing a second opposite signal level, in response to a sequence of received clock pulses;

characterized by that

a) the logical circuit means further receives an external start signal (START) which causes said logical circuit means to start a timing cycle by changing the binary signal provided to said first cell from the first to the second level,

b) a first feed back signal from an EXCLUSIVE OR circuit (Gn) which maintains said second level at the output of said logical circuit means, even after the start signal is removed, and until when both inputs of said EXCLUSIVE OR (Gn) receive said second level,

c) a second feedback signal (TAPN) in output from a cell to which the EXCLUSIVE OR (Gn) for the first feedback signal is connected or from a cell next in sequence thereof, determines said second level at the output of said logical circuit means, at the moment said start signal is received.

2. Digital timing unit as in claim 1 further comprising a synchronization register (11) having a plurality of inputs each one connected to the output of one of said EXCLUSIVE OR circuits, and a clock input connected to the output of said clock pulse generator.

3. Digital timing unit as in claim 1 further comprising second logical circuit means (17, 18, 19, 20, 21, 22, 23) having inputs to receive a binary selection signal (CV), said first feedback signal from an EXCLUSIVE OR circuit (Gn) and second feedback signal (TAPN), a third feedback signal (TAPM) in output from another preestablished one of said cells, and a fourth feedback signal in output from another (Gm) preestablished one of said EXCLUSIVE OR circuits, said second logical circuit means operating to transfer in mutually exclusive way to said first logical circuit means, either said first and second feedback signals or said third and fourth feedback signals, depending on the logical level of said binary selection signal, whereby different timing cycle durations can be obtained from said digital timing unit.

**Patentansprüche**

1. Digitale Zeitsteuereinheit mit einem N-zelligen Schieberegister (10), mit einem ersten Zelleneingang (INDAT), sowie einem Ausgang (TAP$_i$) für jede Zelle, sowie mit einem Takteingang, um bei jedem eingehenden Taktimpuls den am entsprechenden Zelleneingang anstehenden logischen Signalpegel in die erste Zelle zu laden und den logischen Inhalt einer Zelle in die nachfolgende Zelle zu verschieben; wobei mehrere Exklusiv-ODER-Gatter (G1, G2, Gn) jeweils mit ihrem Eingangspaar an ein vorgegebenes Ausgangspaar der Schieberegisters angeschlossen sind;

ein Taktgeber (1) an seinem Ausgang eine Taktimpulsfolge vorgegebener Frequenz liefert, die dem genannten Takteingang zugeführt wird;

eine Logikschaltung (2—9) an ihrem Ausgang den ersten Zelleneingang mit dem einen oder dem anderen von zwei binären Signalpegeln vorsorgt und Eingänge zum Empfang von Rückführsignalen aus den Zellen des Schieberegisters aufweist, um das Schieberegister gesteuert durch eine Folge eingehender Taktimpulse in einem Zeitzyklus von einem ersten Zustand, in dem die Zellen einen ersten Signalpegel aufweisen, in einen zweiten Zustand zu überführen, in dem die Zellen einen zweiten, entgegengesetzten Signalpegel aufweisen; dadurch gekennzeichnet, daß

a) die Logikschaltung ferner ein externes Startsignal (START) empfängt, durch welches die Logikschaltung den Zeitzyklus in Gang setzt, indem das der ersten Zelle zugeführte Binärsignal von einem ersten auf einen zweiten Pegel umgeschaltet wird;

b) ein erstes Rückführsignal einer Exklusiv-ODER-Schaltung (Gn) den zweiten Pegel am Ausgang der Logikschaltung auch dann aufrechterhält, wenn das Startsignal verschwindet, und zwar solange bis beide Eingänge dieser Exklusiv-ODER-Schaltung (Gn) den zweiten Pegel empfangen;

c) ein zweites Rückführsignal (TAPN) als Ausgangsgröße einer Zelle, an die die Exklusiv-ODER-Schaltung (Gn) für das erste Rückführsignal angeschlossen ist, oder als Ausgangsgröße einer nachfolgenden Zelle den zweiten Pegel am Ausgang der Logikschaltung in dem Augenblick bestimmt, wenn das Startsignal ankommt.

2. Digitale Zeitsteuereinheit nach Anspruch 1, gekennzeichnet durch ein Synchronisierregister (11) mit mehreren Eingängen, von denen jeder an den Ausgang einer der Exklusiv-ODER-Schaltungen angeschlossen ist, und durch einen an den Ausgang des Taktgebers angeschlossenen Takteingang.

3. Digitale Zeitsteuereinheit nach Anspruch 1, gekennzeichnet durch eine zweite Logikschaltung (17—23) mit Eingängen zum Empfang eines binären Auswahlsignals (CV);

das erste Rückführsignal von einer Exklusiv-ODER-Schaltung (Gn) sowie das zweite Rückführsignal (TAPN);

ein drittes Rückführsignal (TAPN) als Ausgangsgröße einer anderen vorgegebenen Schieberegisterzelle; und

ein viertes Rückführsignal als Ausgangsgröße einer anderen vorgegebenen Exklusiv-ODER-Schaltung (Gn);

wobei die zweite Logikschaltung in Abhängigkeit vom Logikpegel des binären Auswahlsignals abwechselnd exklusiv der ersten Logikschaltung entweder das erste und das zweite Rückführsignal oder das dritte und das vierte Rückführsignal zuführt, wodurch die Zeitsteuereinheit Zeitzyklen unterschiedlicher Länge erzeugen kann.

**Revendications**

1. Unité de synchronisation numérique dans laquelle un registre à décalage (10) comporte un ensemble de N cellules ordonnées, ayant chacune une première entrée de cellule (INDAT) et une sortie (TAPi), une entrée d'horloge pour charger dans la première cellule le niveau logique de signal présent à l'entrée de cellule correspondante et pour décaler le contenu logique d'une cellule dans la cellule suivante à chaque impulsion d'horloge reçue, dans laquelle un ensemble de circuits OU EXCLUSIF (G1, G2,...,Gn) comporte chacun une paire d'entrées connectée à une paire de sorties préétablies du registre à décalage, dans laquelle un générateur d'impulsions d'horloge (1) fournit à sa sortie une série d'impulsions d'horloge ayant une fréquence préétablie, les impulsions d'horloge étant envoyées à l'entrée d'horloge, et dans laquelle un circuit logique (2, 3, 4, 5, 6, 7, 8, 9) a une sortie fournissant à la première entrée de cellule l'un ou l'autre des niveaux binaires de signal et a des entrées pour recevoir des signaux de réaction des cellules de registre à décalage pour que le registre à décalage passe, pendant un cycle de synchronisation, d'un premier état dans lequel les cellules contiennent un premier niveau de signal à un second état dans lequel les cellules contiennent un second niveau de signal opposé, en réponse à une série d'impulsions d'horloge reçues, caractérisée en ce que le circuit logique reçoit en outre:

a) un signal de lancement extérieur (START) entraînant le lancement d'un cycle de synchronisation par le circuit logique en faisant passer le signal binaire fourni à la première cellule du premier au second niveau,

b) un premier signal de réaction provenant d'un circuit OU EXCLUSIF (Gn) qui maintient le second niveau à la sortie du circuit logique, même après suppression du signal de lancement, et jusqu'à ce que les deux entrées du circuit OU EXCLUSIF (Gn) reçoive le second niveau,

c) un second signal de réaction (TAPN) provenant de la sortie d'une cellule à laquelle est connecté le circuit DU EXCLUSIF (Gn) pour le premier signal de réaction ou d'une cellule suivante dans l'ordre, qui détermine le second niveau à la sortie du circuit logique, au moment où est reçu le signal de lancement.

2. Unité de synchronisation numérique selon la revendication 1, caractérisé en ce qu'elle comprend en outre un registre de synchronisation (11) comportant un ensemble d'entrées connectées chacune à la sortie de l'un des circuits OU EXCLUSIF, et une entrée d'horloge connectée à la sortie du générateur d'impulsions d'horloge.

3. Unité de synchronisation numérique selon la revendication 1, caractérisée en ce qu'elle comprend en outre un second circuit logique (17, 18, 19, 20, 21, 22, 23) comportant des entrées pour recevoir un signal de sélection binaire (CV), le premier signal de réaction provenant d'un circuit OU EXCLUSIF (Gn) et le second signal de réaction (TAPN), un troisième signal de réaction (TAPM) provenant de la sortie d'une autre cellule préétablie desdites cellules, et un quatrième signal de réaction provenant de la sortie d'un autre circuit (Gm) préétabli desdits circuits OU EXCLUSIF, le second circuit logique fonctionnant pour transférer selon la fonction OU exclusif au premier circuit logique, soit les premier et second signaux de réaction soit les troisième et quatrième signaux de réaction, en fonction du niveau logique du signal de sélection binaire, ce qui permet d'obtenir des durées de cycle de synchronisation différents à partir de l'unité de synchronisation numérique.

FIG. 1

FIG. 2

FIG.3